# EUROPEAN PATENT APPLICATION

(11) **EP 4 310 942 A1**
(43) Date of publication of application: **24.01.2024**
(21) Application number: 23786998.7
(22) Date of filing: 10.01.2023
(51) Int. Cl.: H01M 4/136, H01M 4/58, H01M 4/525, H01M 4/505, H01M 10/052, H01M 4/02

(54) **LITHIUM SECONDARY BATTERY ALLOWING EASY STATE ESTIMATION**

(30) Priority: 13.04.2022 KR 20220045855
(71) Applicant: LG ENERGY SOLUTION, LTD., Seoul 07335 (KR)
(72) Inventor: KO, Young Jun, Daejeon 34122 (KR); SUNG, Joo Hwan, Daejeon 34122 (KR); JUNG, Kyung Hwan, Daejeon 34122 (KR)
(74) Representative: Goddar, Heinz J.
(86) International application number: PCT/KR2023/000436
(87) International publication number: WO 2023/200082

(57) **Abstract**

Disclosed herein relates to a positive electrode for a lithium secondary battery and a lithium secondary battery including the same, and since the positive electrode contains a first positive electrode active material including an iron phosphate compound and a second positive electrode active material including a lithium composite metal oxide in a multi-layered positive electrode mixture layer, it is possible to display a large voltage deviation for each state of charge (SOC) of a secondary battery. Therefore, when applying a secondary battery, there is an advantage in that the state of charge (SOC) can be easily estimated and/or measured with high reliability. In addition, the positive electrode for a lithium secondary battery has an advantage in terms of the output performance of the secondary battery being excellent because the energy density of the battery can be increased by containing a lithium composite metal oxide in a positive electrode mixture layer spaced apart from a positive electrode current collector among a plurality of positive electrode mixture layers.

## Description

### [Technical Field]

The present invention relates to a lithium secondary battery capable of easily determining the state of charge of the battery.

This application claims the benefit of priority based on Korean Patent Application No. 10-2022-0045855 filed on April13, 2022, and all contents disclosed in the documents of the Korean Patent Application are included as part of this specification.

### [Background Technology of the Invention]

Recently, secondary batteries have been widely applied not only to small devices such as portable electronic devices, but also to medium and large-sized devices such as battery packs or power storage devices of hybrid vehicles and electric vehicles.

A secondary battery includes an electrode assembly including a positive electrode, a negative electrode, and a separator, and an electrolyte, and includes a multi-layered exterior material that protects them as a body, and such a secondary battery can be used in the form of a battery module equipped with a plurality of cells.

Since high energy density is required to apply these secondary batteries to medium and large-sized devices, high capacity is embodied by using LiNiₐCo_{b}Mn_{c}O₂ (0.6≤a≤0.9, a+b+c=1) with a Ni content of 60% or more, lithium nickel metal oxides with a layered structure as a positive electrode active material.

However, the degradation of battery characteristics due to the decrease in structural stability according to the increase in nickel content in lithium nickel metal oxide, especially a deterioration of battery characteristics and a decrease in thermal stability in a high-temperature environment, is becoming an obstacle to commercialization.

On the other hand, since lithium iron phosphate (LiFePO₄) having an olivine structure has the most excellent structural stability, it is a promising active material with excellent lifespan characteristics and excellent safety in every aspect including overcharge and overdischarge. In particular, lithium iron phosphate (LiFePO₄) has excellent high-temperature stability due to the strong binding force of PO₄, has a lower cost than the above-mentioned LiCoO₂, LiNiO₂, or LiMn₂O₄ because it contains abundant and inexpensive iron, and has a small effect on the environment due to its low toxicity.

However, the change in voltage of lithium iron phosphate (LiFePO₄) during charging and discharging is minimal and remains constant, so it is difficult to estimate the state of charge (SOC) of a secondary battery, and accordingly, there is a problem in that it is not easy to manage the power of a device using a secondary battery.

Also, when manufacturing a positive electrode active material slurry using lithium iron phosphate (LiFePO₄), if the solid content is 80 wt.% or more, the viscosity becomes excessively high, making it difficult to transfer through pipes and causing very low coating properties, making a positive electrode manufacturing difficult. To solve this problem, if the solid content is reduced, the energy density is reduced, resulting in a significant reduction in the output characteristics of the secondary battery.

Therefore, there is a demand for the development of technology that includes lithium iron phosphate (LiFePO₄) as a positive electrode active material, and enables easy estimation of the state of charge of the battery and high output.

### [Prior Art Documents]

### [Patent Document]

Korean Patent Publication No. 10-2020-0024980
Korean Patent Publication No. 10-2014-0017470

### [Description of the Invention]

### [Technical Problem]

Accordingly, the present invention is directed to provide a lithium secondary battery includes lithium iron phosphate (LiFePO₄) as a positive electrode active material, and easy to estimate the state of charge of the battery and enables high output due to high energy density.

### [Technical Solution]

To solve the above-mentioned problems,

In an exemplary embodiment, the present invention provides a positive electrode for a lithium secondary battery, the positive electrode comprising:
a positive electrode current collector; and
n (where n≥2) positive electrode mixture layers are positioned on a positive electrode current collector,
wherein a first positive electrode mixture layer contacting a surface of the positive electrode current collector contains a first positive electrode active material comprising an iron phosphate compound represented by Formula 1 below, and
wherein the second to n^{th} positive electrode mixture layers disposed on the first positive electrode mixture layer comprise the first positive electrode active material comprising the iron phosphate compound represented by Formula 1, and a second positive electrode active material comprising a lithium composite metal oxide represented by Formula 2:

   [Formula 1] LiFeₐM¹₁₋ₐXO₄

   [Formula 2] Liₓ[Ni_{y}Co_{z}Mn_{w}M²ᵥ]O₂

   In Formula 1 and Formula 2,
   M¹ is one or more elements selected from the group consisting of W, Cu, Fe, V, Cr, Co, Ni, Mn, Ti, Zr, Zn, Al, In, Ta, Y, La, Sr, Ga, Sc, Gd, Sm, Ca, Ce, Nb, Mg, B, and Mo,
   X is one or more elements selected from the group consisting of P, Si, S, As, and Sb,
   a is 0≤a≤0.5,
   M² is one or more elements selected from the group consisting of W, Cu, Fe, V, Cr, Ti, Zr, Zn, Al, In, Ta, Y, La, Sr, Ga, Sc, Gd, Sm, Ca, Ce, Nb, Mg, B, and Mo, and
   x, y, z, w, and v are 1.0≤x≤1.30, 0.1≤y<1, 0≤z≤1, 0≤w≤1, 0≤v≤0.1, respectively, where y+z+w+v=1.

Here, the average particle size of the first positive electrode active material may tend to decrease as the position of the positive electrode mixture layer changes from the first positive electrode mixture layer in contact with the positive electrode current collector to the n^{th} positive electrode mixture layer.

In addition, the concentration of the second positive electrode active material may tend to increase as the position of the second positive electrode active material changes from the second positive electrode mixture layer in contact with the first positive electrode mixture layer to the n^{th} positive electrode mixture layer most spaced apart from the first positive electrode mixture layer.

Moreover, an average particle size of the second positive electrode active material may tend to increase as the position of the positive electrode mixture layer changes from the second positive electrode mixture layer in contact with the first positive electrode mixture layer to the n^{th} positive electrode mixture layer most spaced apart from the first positive electrode mixture layer.

Meanwhile, the second positive electrode active material may be included in an amount of less than 10 wt.% based on a total weight of the n positive electrode mixture layers, and may be included in each of the second to n^{th} positive electrode mixture layers in an amount of 0.5 to 20 wt.% based on the weight of each of the second to n^{th} positive electrode mixture layers.

In addition, a total thickness of the n positive electrode mixture layers may be 50µm to 200µm, and a thickness of the first positive electrode mixture layer among the positive electrode mixture layer may be 10% to 60% of the total thickness of the n positive electrode mixture layers.

Furthermore, when applied to a secondary battery, the positive electrode may have a change in voltage of 5mV to 60mV per SOC 1% in a range of SOC 30 to 70%; and/or may have a change in voltage of 0.1mV to 60mV per SOC 1% in a range of SOC 65 to 95%.

In addition, in an exemplary embodiment, the present invention provides an electrode assembly for a lithium secondary battery, the electrode assembly comprising:
the above-described positive electrode according to the present invention;
a negative electrode; and
a separator interposed between the positive electrode and the negative electrode.

Here, the negative electrode may include a negative electrode current collector and a negative electrode mixture layer on a negative electrode current collector, and the negative electrode mixture layer may include one or more carbon-based negative electrode active materials of natural graphite, artificial graphite, expanded graphite, hard carbon, soft carbon, carbon fiber, carbon black, carbon nanotube, fullerene, activated carbon, acetylene black, or ketjen black.

Furthermore, in an exemplary embodiment,
the present invention provides a lithium secondary battery including:
the above-described electrode assembly according to the present invention;
a battery case into which the electrode assembly is inserted; and
an electrolyte composition injected into a battery case together with an electrode assembly.

Here, the type of the lithium secondary battery is not particularly limited, but may be a prismatic secondary battery.

### [Advantageous Effects]

Since the positive electrode for a lithium secondary battery according to the present invention contains a first positive electrode active material including an iron phosphate compound and a second positive electrode active material including a lithium composite metal oxide in a multi-layered positive electrode mixture layer, it can display a large voltage deviation for each state of charge (SOC) of a secondary battery, thereby there is an advantage in that the state of charge (SOC) can be easily estimated and/or measured with high reliability when using a secondary battery.

In addition, the positive electrode for a lithium secondary battery can increase the energy density of a battery by containing a lithium composite metal oxide in a positive electrode mixture layer spaced apart from a positive electrode current collector among a plurality of positive electrode mixture layers, and thus has an advantage of excellent output performance of the secondary battery.

### [Brief description of the drawings]

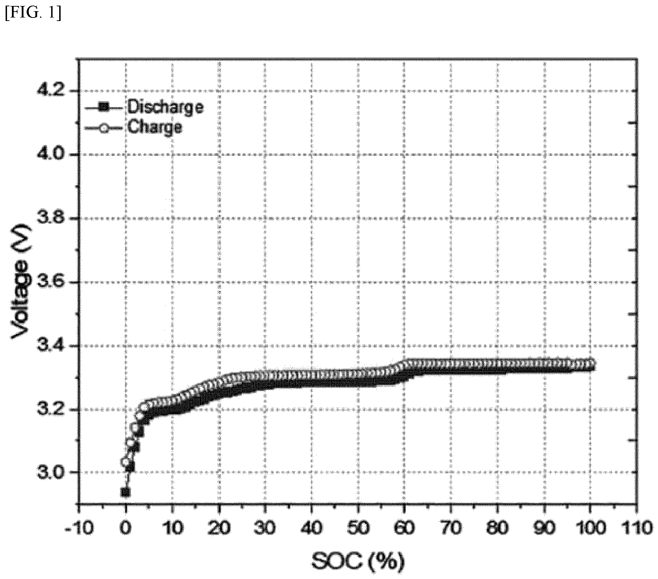

FIG. 1 is a graph showing a change in voltage according to the state of charge (SOC) of a lithium secondary battery (negative electrode active material: graphite) containing lithium iron phosphate (LiFePO₄) as a positive electrode active material.

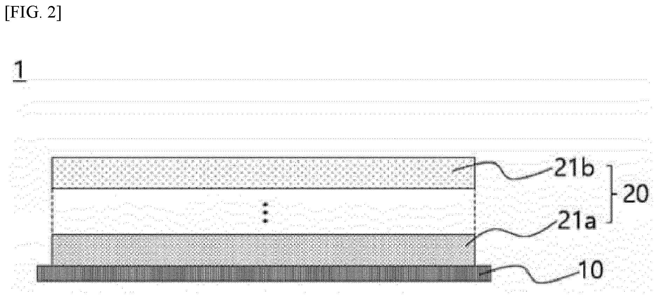

FIG. 2 is a cross-sectional view showing a structure of a positive electrode for a lithium secondary battery according to the present invention.

### [Best Mode for Carrying Out the invention]

The present invention can apply various modifications and have various embodiments. Specific exemplary embodiments will be exemplified in the diagrams and described in detail in the detailed description.

However, it should be understood that the present invention is not limited to specific embodiments, and includes all modifications, equivalents or alternatives within the spirit and technical scope of the present invention.

The terms "comprise" or "have" are used herein to designate the presence of characteristics, numbers, steps, actions, components or members described in the specification or a combination thereof, and it should be understood that the possibility of the presence or addition of one or more other characteristics, numbers, steps, actions, components, members or a combination thereof is not excluded in advance.

In addition, when a part of a layer, a film, a region or a plate, etc. is disposed "on" another part, this includes not only a case in which one part is disposed "directly on" another part, but a case in which a third part is interposed therebetween. In contrast, when a part of a layer, a film, a region or a plate, etc. is disposed "under" another part, this includes not only a case in which one part is disposed "directly under" another part, but a case in which a third part is interposed therebetween. In addition, in this application, "on" may include not only a case of disposed on an upper part but also a case of disposed on a lower part.

Hereinafter, the present invention will be described in more detail.

### Positive electrode for lithium secondary battery

In an exemplary embodiment, the present invention provides a positive electrode for a lithium secondary battery, the positive electrode comprising:
a positive electrode current collector; and
n (where n≥2) positive electrode mixture layers are positioned on a positive electrode current collector,
wherein a first positive electrode mixture layer contacting the surface of the positive electrode current collector contains a first positive electrode active material comprising an iron phosphate compound represented by Formula 1 below, and
wherein the n-1 positive electrode mixture layers disposed on the first positive electrode mixture layer comprise a first positive electrode active material comprising an iron phosphate compound represented by Formula 1, and a second positive electrode active material comprising a lithium composite metal oxide represented by Formula 2.

   [Formula 1] LiFeₐM¹₁₋ₐXO₄

   [Formula 2] Liₓ[Ni_{y}Co_{z}Mn_{w}M²ᵥ]O₂

   In Formula 1 and Formula 2,
   M¹ is one or more elements selected from the group consisting of W, Cu, Fe, V, Cr, Co, Ni, Mn, Ti, Zr, Zn, Al, In, Ta, Y, La, Sr, Ga, Sc, Gd, Sm, Ca, Ce, Nb, Mg, B, and Mo,
   X is one or more elements selected from the group consisting of P, Si, S, As, and Sb,
   a is 0≤a≤0.5,
   M² is one or more elements selected from the group consisting of W, Cu, Fe, V, Cr, Ti, Zr, Zn, Al, In, Ta, Y, La, Sr, Ga, Sc, Gd, Sm, Ca, Ce, Nb, Mg, B, and Mo, and
   x, y, z, w, and v are 1.0≤x≤1.30, 0.1≤y<1, 0≤z≤1, 0≤w≤1, 0≤v≤0.1, respectively, where y+z+w+v=1.

The positive electrode for a lithium secondary battery according to the present invention includes a positive electrode current collector and a multilayer positive electrode mixture layer in which two or more individual mixture layers are stacked on the positive electrode current collector.

Specifically, the positive electrode mixture layer has a structure in which n (where n≥2) individual positive electrode mixture layers are stacked on the positive electrode current collector. Here, the positive electrode mixture layer stacked on the surface contacting the positive electrode current collector is a first positive electrode mixture layer, and the second positive electrode mixture layer to the n^{th} positive electrode mixture layer are sequentially stacked on the first positive electrode mixture layer, so that n individual positive electrode mixture layers are positioned on the positive electrode current collector.

The number of positive electrode mixture layers is not particularly limited as long as the positive electrode mixture layer has a structure of two or more layers, but specifically, it may be 2 to 10 layers; 2 to 8 layers; 2 to 6 layers; or 2 to 4 layers. By controlling the number of layers of the positive electrode mixture layer within the above range, the present invention may increase the energy density of the electrode while preventing a decrease in the manufacturing efficiency of the positive electrode, and at the same time, heat generated during charging and discharging of the battery can be effectively released to the outside.

In addition, the positive electrode mixture layer is prepared by applying, drying, and pressurizing a slurry containing a positive electrode active material capable of reversible intercalation and deintercalation of lithium ions during charging and discharging of a battery, and the positive electrode active material may be included in different types and/or amounts in each layer.

Specifically, the positive electrode according to the present invention includes a first positive electrode active material including an iron phosphate compound represented by Formula 1 in a positive electrode mixture layer, and the positive electrode mixture layer spaced apart from the positive electrode current collector, that is the n-1 positive electrode mixture layers disposed on the first positive electrode mixture layer, further includes a second positive electrode active material including a lithium composite metal oxide represented by Formula 2:

[Formula 1] LiFeₐM¹₁₋ₐXO₄

[Formula 2] Liₓ[Ni_{y}Co_{z}Mn_{w}M²ᵥ]O₂

M¹ is one or more elements selected from the group consisting of W, Cu, Fe, V, Cr, Co, Ni, Mn, Ti, Zr, Zn, Al, In, Ta, Y, La, Sr, Ga, Sc, Gd, Sm, Ca, Ce, Nb, Mg, B, and Mo,
X is one or more elements selected from the group consisting of P, Si, S, As, and Sb,
a is 0≤a≤0.5,
M² is one or more elements selected from the group consisting of W, Cu, Fe, V, Cr, Ti, Zr, Zn, Al, In, Ta, Y, La, Sr, Ga, Sc, Gd, Sm, Ca, Ce, Nb, Mg, B, and Mo, and
x, y, z, w, and v are 1.0≤x≤1.30, 0.1≤y<1, 0≤z≤1, 0≤w≤1, 0≤v≤0.1, respectively, where y+z+w+v=1.

The iron phosphate compound represented by Formula 1 has an olivine structure and has the most excellent structural stability. Therefore, it has excellent lifespan characteristics and is a promising active material with excellent safety in every aspect including overcharge and overdischarge. In particular, lithium iron phosphate (LiFePO₄) has excellent high-temperature stability due to the strong binding force of PO₄, has a lower cost than the above-mentioned LiCoO₂, LiNiO₂, or LiMn₂O₄ because it contains abundant and inexpensive iron, and has a small effect on the environment due to its low toxicity. On the other hand, the change in voltage of lithium iron phosphate (LiFePO₄) during charging and discharging is minimal and remains constant, so it is difficult to estimate the state of charge (SOC) of a secondary battery, and accordingly, there is a problem in that it is not easy to manage the power of a device using a secondary battery. Moreover, when manufacturing the positive electrode mixture layer, if the solid content of the lithium iron phosphate (LiFePO₄) is controlled to be as high as 80wt.% or more, process efficiency is lowered, so when this is improved, there is a limit where the output is reduced due to a decrease in energy density.

Accordingly, the positive electrode according to the present invention has a structure that includes an iron phosphate compound represented by Formula 1 having an olivine crystal structure that has excellent stability as the first positive electrode active material, and further includes a second positive electrode active material containing a lithium composite metal oxide represented by Formula 2 in the positive electrode mixture layer. Thus, the state of charge (SOC) of a battery can be easily and reliably measured while improving the battery's output.

Here, the iron phosphate compound represented by Formula 1 is a lithium phosphate containing iron, and in some cases, may have a form doped with another transition metal (M¹). For example, the iron phosphate compound may include LiFePO₄, LiFe_{0.8}Mn_{0.2}PO₄, LiFe_{0.5}Mn_{0.5}PO₄, and the like.

Here, the first positive electrode active material may have an average particle size of 0.5 to 5µm, specifically 0.5 to 1.0µm; 0.8 to 1.2µm; 1.0 to 2.0µm; 1.5 to 3.0µm; 2.0 to 3.0µm; or it may have an average particle size of 2.5 to 4.0µm.

In addition, while the first positive electrode active material is included in each positive electrode mixture layer, the average particle size may tend to decrease as the position of the positive electrode mixture layer changes from the first positive electrode mixture layer in contact with the positive electrode current collector to the n^{th} positive electrode mixture layer.

Specifically, the first positive electrode active material included in the first positive electrode mixture layer may have an average particle size of 1.2 to 1.9µm, and the first positive electrode active material included in the n^{th} positive electrode mixture layer (where n≥2) may have an average particle size of 0.5 to 0.9µm.

As an example, the first positive electrode active material included in the first positive electrode mixture layer may have an average particle size of 1.2 to 1.9µm, and the first positive electrode active material included in the second positive electrode mixture layer may have an average particle size of 0.5 to 0.9µm,

As another example, the first positive electrode active material included in the first positive electrode mixture layer may have an average particle size of 1.5 to 1.9µm, the first positive electrode active material included in the second positive electrode mixture layer may have an average particle size of 1.1 to 1.4µm, and the first positive electrode active material included in the third positive electrode mixture layer may have an average particle size of 0.5 to 0.9µm.

Since the present invention can increase the ion mobility on the surface of the positive electrode by adjusting the average particle size of the first positive electrode active material contained in each positive electrode mixture layer to decrease as it progresses from the position adjacent to the positive electrode current collector to the most spaced apart position, it may improve the output of the battery.

In addition, the lithium composite metal oxide represented by Formula 2 is a metal oxide containing nickel (Ni), cobalt (Co), and manganese (Mn) together with lithium, and in some cases, may have a form doped with another transition metal (M²). In a specific example, more specifically, the lithium composite metal oxide may include one or more selected from the group consisting of Li(Ni_{0.6}Co_{0.2}Mn_{0.2})O₂, Li(Ni_{0.7}Co_{0.15}Mn_{0.15})O₂, Li(Ni_{0.8}Co_{0.1}Mn_{0.1})O₂, Li(Ni_{0.9}Co_{0.05}Mn_{0.05})O₂, Li(Ni_{0.6}Co_{0.2}Mn_{0.1}Zr_{0.1})O₂, Li(Ni_{0.6}Co_{0.2}Mn_{0.15}Zr_{0.05})O₂, and Li(Ni_{0.7}Co_{0.1}Mn_{0.1}Zr_{0.1})O₂.

The particle size of the second positive electrode active material is not particularly limited, but may specifically have an average particle size of 0.5 to 5µm, more specifically 0.8 to 1.5µm; 1.0 to 3.0µm; 1.2 to 1.8µm; or it may have an average particle size of 1.5 to 2.5µm.

In addition, unlike the first positive electrode active material, as the position of the second positive electrode active material is changed from the second positive electrode mixture layer in contact with the first positive electrode mixture layer to the n^{th} positive electrode mixture layer most spaced apart from the first positive electrode mixture layer, the average particle size may tend to increase.

Specifically, the second positive electrode active material included in the second positive electrode mixture layer may have an average particle size of 0.5 to 1.2µm, and the second positive electrode active material included in the nth positive electrode mixture layer (wheren≥2) may have an average particle size of 1.3 to 3.0µm.

As an example, the second positive electrode active material included in the second positive electrode mixture layer may have an average particle size of 0.8 to 1.0µm, and the second positive electrode active material included in the third positive electrode mixture layer may have an average particle size of 1.2 to 1.5µm.

As another example, the second positive electrode active material included in the second positive electrode mixture layer may have an average particle size of 0.6 to 0.8µm, the second positive electrode active material included in the third positive electrode mixture layer may have an average particle size of 1.5 to 1.8µm, and the second positive electrode active material included in the fourth positive electrode mixture layer may have an average particle size of 2.0 to 2.2µm.

The positive electrode of the present invention increases the average particle size of the second positive electrode active material as the position of the individual positive electrode mixture layer changes from the second positive electrode mixture layer to the n^{th} positive electrode mixture layer, thereby increasing the energy density of the battery.

In addition, the second positive electrode active material may be included in an amount of less than 10wt.% based on the total weight of the positive electrode mixture layer, specifically may be included in an amount of 0.1 to 9.9wt.% based on the total weight of the positive electrode mixture layer; 0.5 to 8.0wt.%; 0.5 to 6.0wt.%; 0.1 to 5.0wt.%; 0.1 to 3.0wt.%; 1.0 to 3.0wt.%; 2.5 to 5.0wt.%; 4.0 to 8.0wt.%; or 6.0 to 9.9wt.%.

Moreover, the second positive electrode active material may be included in each positive electrode mixture layer in an amount of 0.5 to 20 wt.% based on the weight of each positive electrode mixture layer, and specifically may be included in an amount of 1 to 18 wt.% based on the weight of each positive electrode mixture layer; 1 to 15wt.%; 1 to 12wt.%; 1 to 10 wt.%; 1 to 8 wt.%; 1 to 5 wt.%; 0.5 to 1 wt.%; 0.5 to 5 wt.%; 2 to 6 wt.%; 0.5 to 0.9 wt.%; 5 to 16 wt.%; 7 to 15 wt.%; or 8 to 12 wt.%.

In the present invention, by controlling the content of the second positive electrode active material based on the total weight of the positive electrode mixture layer and individual positive electrode mixture layer within the above-mentioned range, it is possible to prevent SOC estimation reliability from deteriorating due to the voltage change of the positive electrode according to the state of charge of the battery not being sufficiently implemented due to the insignificant content, and it is possible to prevent excessive generation of heat from the positive electrode during charging and discharging due to an excessive amount of the second positive electrode active material.

Furthermore, the second positive electrode active material is included in the second positive electrode mixture layer to the n^{th} positive electrode mixture layer, and its concentration may tend to increase as its position changes from the second positive electrode mixture layer in contact with the first positive electrode mixture layer to the n^{th} positive electrode mixture layer most spaced apart from the first positive electrode mixture layer. Here, `concentration increases' may mean that the content or content ratio of the second positive electrode active material increases based on the total weight of the individual positive electrode mixture layer.

The second positive electrode active material has a high ion mobility and a high energy density compared to the first positive electrode active material. The positive electrode of the present invention increases the concentration of the second positive electrode active material toward the outermost positive electrode mixture layer facing the negative electrode through the separator among the plurality of positive electrode mixture layers located on the positive electrode current collector, thereby further improving the output of the battery.

Since the positive electrode for a lithium secondary battery according to the present invention has the above-described configuration, it is possible to implement a large voltage change according to the state of charge, and thus has an advantage of being able to easily estimate the state (SOC) of the battery.

Specifically, when applied to a secondary battery, the positive electrode may exhibit a change in voltage of 5mV to 60mV per SOC 1% in the range of SOC 30 to 70% at 25°C, specifically may exhibit a voltage change of 10mV to 50mV; 20mV to 50mV; 30mV to 50mV; 35mV to 45mV; 40mV to 48mV; or 42mV to 45mV.

As an example, when the positive electrode is applied to a secondary battery containing graphite as a negative electrode active material, it may exhibit a change in voltage of 43.1mV to 44.0mV per SOC 1% in the range of SOC 30 to 70% at 25°C.

In addition, when applied to a secondary battery, the positive electrode may exhibit a change in voltage of 0.1mV to 60mV per SOC 1% in the range of SOC 65 to 95% at 25°C, and specifically may exhibit a change in voltage of 0.1mV to 40mV; 0. 1mV to 20mV; 0.1mV to 10mV; 1mV to 10mV; 2.5mV to 10 mV; or 3.0mV to 7.0mV.

As an example, when the positive electrode is applied to a secondary battery containing graphite as a negative electrode active material, it may exhibit a change in voltage of 2.5mV to 9mV per SOC 1% in the range of SOC 65 to 95% at 25°C.

When applied to a secondary battery, the positive electrode according to the present invention has such a large voltage deviation for each section of the state of charge (SOC), so that the state of charge of the battery can be easily estimated and/or measured with high reliability, which is an advantage in that the power of devices using secondary batteries can be conveniently managed, and the change in voltage may vary depending on the type of the negative electrode active material.

Meanwhile, the positive electrode for a lithium secondary battery according to the present invention may further include a conductor, a binder, other additives, and the like in the positive electrode mixture layer, if necessary.

In this case, the first and second positive electrode active materials contained in each positive electrode mixture layer may be included in an amount of 85 parts by weight or more, specifically, 90 parts by weight or more, 93 parts by weight or more, or 95 parts by weight or more based on the weight of each positive electrode mixture layer.

In addition, the conductor is used to improve the electrical performance of the positive electrode, and those commonly used in the art can be applied, but specifically, may include one or more selected from the group consisting of natural graphite, artificial graphite, carbon black, acetylene black, and Denka black, ketjen black, Super-P, channel black, furnace black, lamp black, thermal black, graphene, and carbon nanotube.

Moreover, the conductor may be included in an amount of 0.1 to 5 parts by weight based on the weight of each positive electrode mixture layer, specifically may be included in an amount of 0.1 to 4 parts by weight; 2 to 4 parts by weight; 1.5 to 5 parts by weight; 1 to 3 parts by weight; 0.1 to 2 parts by weight; or 0.1 to 1 part by weight.

In addition, the binder serves to bind the positive electrode active material, the positive electrode additive, and the conductor to each other, and any binder having such a function may be used without particular limitation. Specifically, the binder may include one or more resins selected from the group consisting of polyvinylidene fluoride-hexafluoropropylene copolymer (PVdF-co-HFP);polyvinylidenefluoride (PVdF), polyacrylonitrile, polymethylmethacrylate, and copolymers thereof. As one example, the binder may include polyvinylidenefluoride.

Moreover, the binder may be included in an amount of 1 to 10 parts by weight based on the weight of each positive electrode mixture layer, specifically 2 to 8 parts by weight; or may include 1 to 5 parts by weight of the conductor.

In addition, the total thickness of the positive electrode mixture layer is not particularly limited, but may be specifically 50µm to 300µm, more specifically 100µm to 200µm; 80µm to 150µm; 120µm to 170µm; 150µm to 300µm; 200µm to 300µm; or 150µm to 190µm.

Also, among the individual positive electrode mixture layers constituting the positive electrode mixture layer, the thickness of the first positive electrode mixture layer contacting the positive electrode current collector may be adjusted within a certain range. Specifically, the thickness of the first positive electrode mixture layer may be 10% to 60% of the total thickness of the positive electrode mixture layer, and more specifically, 10% to 40% of the total thickness of the positive electrode mixture layer; 30% to 50%; 10% to 20%; or 40% to 60%.

In the present invention, by adjusting the total thickness and individual thickness of the positive electrode mixture layer within the above range, it is not only possible to prevent the energy density of the electrode from being reduced, but also to display high adhesive force between the positive electrode current collector and the positive electrode mixture layer.

Furthermore, the positive electrode current collector provided in the positive electrode may be one having high conductivity without causing chemical change in the battery. For example, stainless steel, aluminum, nickel, titanium, calcined carbon, etc. may be used, and in the case of aluminum or stainless steel, ones that are surface-treated with carbon, nickel, titanium, silver, or the like may also be used.

In addition, the average thickness of the current collector may be appropriately adjusted in the range of 5 to 500µm in consideration of the conductivity and total thickness of the positive electrode to be manufactured.

### Electrode assembly for lithium secondary battery

In addition, in an exemplary embodiment,
the present invention provides an electrode assembly for a lithium secondary battery including: the above-described positive electrode according to the present invention; a negative electrode; and a separator interposed between the positive electrode and the negative electrode.

Since the electrode assembly for a lithium secondary battery according to the present invention can display a large voltage deviation for each state of charge (SOC) of the secondary battery by being provided with the above-described positive electrode of the present invention, it can easily estimate and/or measure the state of charge (SOC) with high reliability when using the secondary battery. Moreover, since the electrode assembly can increase the energy density of the battery by containing lithium composite metal oxide in an individual positive electrode mixture layer spaced apart from the positive electrode current collector among the plurality of positive electrode mixture layers, the secondary battery has an excellent output performance.

Here, since the positive electrode has the same configuration as the above-described positive electrode for a lithium secondary battery of the present invention, a description of the detailed configuration will be omitted.

In addition, the negative electrode includes a negative electrode mixture layer prepared by applying, drying, and pressurizing a negative electrode active material on a negative electrode current collector in the same manner as the positive electrode, and if necessary, may further include a conductor, a binder, other electrolyte additives, and the like.

Here, the negative electrode active material may be one commonly used in the art, but specifically, it may include one or more carbon-based negative electrode active materials among natural graphite, artificial graphite, expanded graphite, hard carbon, soft carbon, carbon fiber, carbon black, carbon nanotube, fullerene, activated carbon, acetylene black, and ketjen black.

Moreover, while the negative electrode mixture layer displays an adhesive force with the negative electrode current collector, it may include a binder so that the negative electrode active material, the conductor, other additives, and the like may bind to each other. Such binders include polyvinylidene fluoride (PVDF), polyvinylidene fluoride-hexafluoropropylene copolymer (PVDF-co-HFP), polyvinylalcohol, polyacrylonitrile, carboxymethylcellulose (CMC),starch, hydroxypropyl cellulose, regenerated cellulose, polyvinylpyrrolidone,
polytetrafluoroethylene, polyethylene, polypropylene, ethylene-propylene-diene monomer rubber (EPDM rubber), sulfonated-EPDM, styrene-butadiene rubber (SBR), fluoro-rubber, or various copolymers thereof, and the like, and one alone or a mixture of two or more of these may be used. The binder may be included in an amount of 1 to 10 parts by weight based on the weight of the negative electrode mixture layer, specifically 2 to 8 parts by weight; or may include 1 to 5 parts by weight of the conductor.

In addition, the negative electrode mixture layer may have an average thickness of 100µm to 200µm, specifically may have an average thickness of 100µm to 180µm, 100µm to 150µm, 120µm to 200µm, 140µm to 200µm, or 140µm to 160µm.

Furthermore, the negative electrode may include a negative electrode current collector that has conductivity without causing chemical change in the battery. For example, as the negative electrode current collector, copper, stainless steel, aluminum, nickel, titanium, baked carbon, etc. may be used, and in the case of copper or stainless steel, ones that are surface-treated with carbon, nickel, titanium, silver, etc. may be used. In addition, the negative electrode current collector, same as the positive electrode current collector, may form micro/nano-scaled unevenness on the surface to increase the binding force to the negative electrode active material, and it may be used in various forms such as films, sheets, foils, nets, porous materials, foams, non-woven fabrics, etc. Moreover, the average thickness of the negative electrode current collector may be appropriately applied in the range of 3 to 500µm in consideration of the conductivity and total thickness of the negative electrode to be manufactured.

Furthermore, the separator is interposed between the positive electrode and the negative electrode, and an insulating thin film having a high ion permeability and mechanical strength is used. The separator is not particularly limited as long as it is commonly used in the art, but specifically, a chemically resistant and hydrophobic polypropylene; glass fiber; or a sheet or a non-woven fabric made of polyethylene, etc. may be used. In some cases, a composite separator in which inorganic particles/organic particles are coated with an organic binder polymer on a porous polymer substrate such as a sheet or a non-woven fabric may be used. When a solid electrolyte such as a polymer is used as the electrolyte, the solid electrolyte may serve as a separator. Moreover, the separator may have an average pore diameter of 0.01 to 10µm and an average thickness of 5 to 300µm.

### Lithium secondary battery

Furthermore, in an exemplary embodiment,
the present invention provides a lithium secondary battery including:
the above-described electrode assembly according to the present invention;
a battery case into which the electrode assembly is inserted; and
an electrolyte composition injected into a battery case together with an electrode assembly.

The lithium secondary battery according to the present invention includes an electrode assembly including the above-described positive electrode of the present invention, and the electrode assembly may have a structure in which it is inserted into a battery case together with an electrolyte composition.

Here, since the electrode assembly has the same configuration as the above-described electrode assembly of the present invention, description of the detailed configuration will be omitted.

In addition, the electrolyte composition may include an organic liquid electrolyte, an inorganic liquid electrolyte, a solid polymer electrolyte, a gel polymer electrolyte, a solid inorganic electrolyte, a molten inorganic electrolyte, etc. that can be used during manufacture of a lithium secondary battery, but is not limited thereto.

Specifically, the electrolyte may include an organic solvent and a lithium salt.

The organic solvent may be used without particular limitation as long as it can serve as a medium through which ions involved in the electrochemical reaction of the battery can move. For example, as the organic solvent,ester-based solvents such as methyl acetate, ethyl acetate, γ-butyrolactone, ε-caprolactone, etc.; ether-based solvents such as dibutyl ether or tetrahydrofuran; ketone-based solvents such as cyclohexanone; aromatic hydrocarbon-based solvents such as benzene, fluorobenzene, etc.;carbonate-based solvents such as dimethylcarbonate (DMC), diethylcarbonate(DEC), methylethylcarbonate (MEC), ethylmethylcarbonate (EMC), ethylenecarbonate (EC), propylenecarbonate (PC), nitriles such as R-CN (R is a linear, a branched, or a cyclic hydrocarbon group of C2 to C20, and may include a double bond aromatic ring or an ether bond); amides such as dimethylformamide, etc.; dioxolanes such as 1,3-dioxolane; or sulfolanes, etc. may be used. Among the above, carbonate-based solvents are preferred, and a mixture of cyclic carbonates (e.g., ethylene carbonate or propylene carbonate, etc.) having a high ionic conductivity and a high dielectric constant capable of increasing the charging/discharging performance of the battery, and low-viscosity linear carbonate-based compounds (e.g., ethyl methyl carbonate, dimethyl carbonate, or diethyl carbonate, etc.) are more preferable. In this case, when the cyclic carbonate and the chain carbonate are mixed and used in a volume ratio of about 1: 1 to 9, the performance of the electrolyte may be excellent.

In addition, the lithium salt may be used without particular limitation as long as it is a compound capable of providing lithium ions used in the lithium secondary battery. Specifically, as the lithium salt, LiPF₆, LiClO₄, LiAsF₆, LiBF₄, LiSbF₆, LiAlO₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, or LiB(C₂O₄)₂ may be used.

Moreover, the concentration of the lithium salt may be used within the range of 0.1M to 2.0M. When the concentration of the lithium salt is within the above range, the electrolyte has appropriate conductivity and viscosity, so an excellent electrolyte performance can be exhibited, and lithium ions can move effectively.

In the electrolyte, besides the above electrolyte components, for the purpose of improving the lifespan characteristics of the battery, suppressing the decrease in battery capacity, and improving the discharge capacity of the battery, for example, one or more additives such as pyridine, triethyl phosphite, triethanolamine, cyclic ether, ethylene diamine, n-glyme, hexaphosphoric acid triamide, nitrobenzene derivative, sulfur, quinone imine dye, N-substituted oxazolidinone, N, N-substituted imidazolidine, ethylene glycol dialkyl ether, ammonium salt, pyrrole, 2-methoxy ethanol, or aluminum trichloride, etc. may be further included. Here, the additive may be included in an amount of 0.1 to 5wt.% based on the total weight of the electrolyte.

As described above, since the lithium secondary battery including the positive electrode according to the present invention stably exhibits excellent discharge capacity, output characteristics, and capacity retention rate, it is useful in portable devices such as mobile phones, laptops, digital cameras, and electric vehicles such as hybrid electric vehicles (HEVs), etc.

Furthermore, the lithium secondary battery according to the present invention is not limited in appearance depending on the use of the battery, and its shape may be adopted by a case commonly used in the art. For example, the lithium secondary battery may be a battery including a cylindrical or a prismatic battery case using a can, or a pouch-type or a coin-type battery case.

As an example, the lithium secondary battery may be a prismatic secondary battery including a prismatic can as the battery case.

### [Mode for Carrying Out the invention]

Hereinafter, the present invention will be described in more detail by Examples and Experimental Examples.

However, the following Examples and Experimental Examples are merely illustrative of the present invention, and the contents of the present invention are not limited to the following examples.

### Examples 1 to 7 and Comparative Examples 1 to 2. Preparation of positive electrode for lithium secondary battery

N-methylpyrrolidone solvent was injected into a homo mixer, and in order to form the first to third positive electrode mixture layers, LiFePO₄ (hereinafter, 'LFP') as a first positive electrode active material, LiNi_{0.8}Co_{0.1}Mn_{0.1}O₂ (hereinafter, `NCM', average particle size: approx. 2µm) as a second positive electrode active material, carbon black as a conductor, and polyvinylidene fluoride (PVdF) as a binder were injected, respectively. Then, the mixture was mixed at 3,000rpm for 60 minutes to prepare a slurry for forming a first positive electrode mixture layer, a slurry for forming a second positive electrode mixture layer, and a slurry for forming a third positive electrode mixture layer, respectively.

Here, the slurry prepared to form each positive electrode mixture layer was prepared to include 48.5 parts by weight of the positive electrode active material, 1 part by weight of the conductor, and 0.5 part by weight of the binder based on solid content, and the content ratio (unit: parts by weight) of the first positive electrode active material and the second positive electrode active material included in each slurry and the average particle size (unit:µm) of the first positive electrode active material were adjusted as shown in Table 1.

A positive electrode was prepared by preparing an aluminum thin sheet (average thickness: 12µm) as a positive electrode current collector, sequentially casting the prepared slurry for forming the first to third positive electrode mixture layers on the prepared aluminum thin sheet, drying in a vacuum oven at 130°C, and rolling it. Here, the total thickness of the rolled positive electrode mixture layer was 150µm, and the thickness of each individual positive electrode mixture layer was 50µm in the case of a three-layer structure and 75µm in the case of a two-layer structure.

**[Table 1]**

| | Mixture layer structure | First positive electrode mixture layer | | | Second positive electrode mixture layer | | | Third positive electrode mixture layer | | |
|---|---|---|---|---|---|---|---|---|---|---|
| | | NCM content | LFP content | LFP particle size | NCM content | LFP content | LFP particle size | NCM content | LFP content | LFP particle size |
| Example 1 | 2-layer | - | 50 | 1.5 | 5 | 45 | 1.2 | - | - | - |
| Example 2 | 3-layer | - | 50 | 1.5 | 0.5 | 49.5 | 1.2 | 1 | 49 | 0.8 |
| Example 3 | 3-layer | - | 50 | 1.5 | 2.5 | 47.5 | 1.2 | 5 | 45 | 0.8 |
| Example 4 | 3-layer | - | 50 | 1.5 | 4.5 | 45.5 | 1.2 | 9 | 41 | 0.8 |
| Example 5 | 3-layer | - | 50 | 1.5 | 7.5 | 42.5 | 1.2 | 15 | 35 | 0.8 |
| Example 6 | 3-layer | - | 50 | 1.2 | 2.5 | 47.5 | 1.2 | 5 | 45 | 1.2 |
| Example 7 | 3-layer | - | 50 | 1.5 | 3.75 | 46.25 | 1.2 | 3.75 | 46.25 | 0.8 |
| Comparative Example 1 | 1-layer | - | 100 | 1.5 | - | - | - | - | - | - |
| Comparative Example 2 | 1-layer | 5 | 95 | 1.5 | - | - | - | - | - | - |

### Examples 8 to 14 and Comparative Examples 3 to 4. Preparation of electrode assembly and lithium secondary battery

A negative electrode slurry was formed by preparing a negative electrode active material in which natural graphite and artificial graphite were mixed in a weight ratio of 1:1, and mixing 97 parts by weight of the negative electrode active material and 3 parts by weight of styrene-butadiene rubber (SBR) with water, and then it was casted on a copper thin sheet, which was a negative electrode current collector. A negative electrode was prepared by drying and rolling the copper thin sheet on which the negative electrode slurry was cast in a vacuum oven at 130°C. Here, the thickness of the negative electrode mixture layer was 130µm.

As shown in Table 2 below, the prepared negative electrodes were disposed opposite to the positive electrodes prepared in Examples and Comparative Examples, respectively, and a separator made of 18µm polypropylene was interposed therebetween to prepare an electrode assembly. A prismatic lithium secondary battery was prepared by inserting each of the prepared electrode assemblies into a prismatic battery case, injecting an electrolyte composition into the battery case, and sealing the case. Here, as the electrolyte composition, a solution in which lithium hexafluorophosphate (LiPF₆, 1.0M) and vinyl carbonate (VC, 2wt.%) were mixed into a mixture of ethylene carbonate (EC): dimethyl carbonate (DMC): diethyl carbonate (DEC)=1:1:1 (volume ratio) was used.

**[Table 2]**

| | Type of positive electrode used |
|---|---|
| Example 8 | Positive electrode prepared in Example 1 |
| Example 9 | Positive electrode prepared in Example 2 |
| Example 10 | Positive electrode prepared in Example 3 |
| Example 11 | Positive electrode prepared in Example 4 |
| Example 12 | Positive electrode prepared in Example 5 |
| Example 13 | Positive electrode prepared in Example 6 |
| Example 14 | Positive electrode prepared in Example 7 |
| Comparative Example 3 | Positive electrode prepared in Comparative Example 1 |
| Comparative Example 4 | Positive electrode prepared in Comparative Example 2 |

### Experimental Example.

In order to evaluate the effect of the positive electrode for a lithium secondary battery according to the present invention, the following experiment was performed.

### A) Evaluation of voltage deviation for each SOC section

The lithium secondary batteries prepared in Examples and Comparative Examples were charged and discharged three times, respectively, the voltage according to the SOC was measured, and the voltage deviation generated when the SOC was changed by 1% was calculated for each section. Here, the charging and discharging were performed three times at a rate of 0.1C with a cutoff potential of 2.8V and a maximum charging voltage of 3.6V. In addition, the voltage deviation was calculated for: the first section including SOC 30 to 55%; the second section including SOC 30 to 70%; and the third section including SOC 65 to 95%, and the results were shown in Table 3 below.

### B) Evaluation of battery heat generation during charging and discharging

Overcharging was performed on the secondary batteries prepared in Examples and Comparative Examples, and the surface temperature and the internal temperature of the overcharged secondary batteries were measured. Specifically, a heat sensor was installed inside the case of each of the target secondary batteries, and after charging at 4.2V, the charged battery was overcharged with a constant current of 1A until it reached 10V. Then, a constant voltage of 10V was maintained for 6 hours. After 6 hours had passed, the internal temperature of the battery was measured with the heat sensor installed in each secondary battery, the temperature of the secondary battery was measured three times by photographing the surface of each secondary battery with a thermal imaging camera, and the average value was calculated and measured as the surface temperature of the battery during overcharging. The measured results were shown in Table 3 below.

### C) Evaluation of secondary battery output

The lithium secondary batteries prepared in Examples and Comparative Examples were fully charged at room temperature (22°C) at a 0.1C-rate. Then, the initial discharge capacity was measured while discharging the fully charged lithium secondary batteries at 0.1C-rate. After that, each lithium secondary battery was fully charged again at 0.1C-rate, and while discharging at 1.0C, 2.0C, 5.0C, and 9.0C-rates, respectively, the relative discharge capacity ratio based on the initial discharge capacity for each discharge rate was calculated, and the results were shown in Table 4 below.

**[Table 3]**

| | Change in voltage [mV] for a SOC 1% change | | | Battery temperature when overcharged | |
|---|---|---|---|---|---|
| | First section | Second section | Third section | Internal | External |
| Example 8 | 12.3 | 43.5 | 5.1 | 45±1°C | 36±1°C |
| Example 9 | 11.8 | 43.1 | 2.9 | 41±1°C | 33±1°C |
| Example 10 | 12.4 | 43.5 | 5.1 | 42±1°C | 33±1°C |
| Example 11 | 13.3 | 43.9 | 7.9 | 45±1°C | 36±1°C |
| Example 12 | 14.2 | 44.3 | 8.5 | 54±1°C | 42±1°C |
| Example 13 | 12.3 | 43.5 | 5.1 | 45±1°C | 36±1°C |
| Example 14 | 12.4 | 43.5 | 5.1 | 42±1°C | 33±1°C |
| Comparative Example 3 | 11.6 | 43.0 | 2.3 | 41±1°C | 32±1°C |
| Comparative Example 4 | 12.2 | 43.5 | 5.0 | 47±1°C | 38±1°C |

**[Table 4]**

| | Ratio of relative discharge capacity to C rate discharge capacity [%] | | | |
|---|---|---|---|---|
| | 1.0C | 2.0C | 5.0C | 9.0C |
| Example 8 | 99.2 | 98.1 | 91.5 | 78.6 |
| Example 9 | 99.2 | 97.7 | 99.3 | 75.1 |
| Example 10 | 99.6 | 98.9 | 91.8 | 79.6 |
| Example 11 | 99.7 | 99.2 | 92.8 | 81.9 |
| Example 12 | 99.9 | 99.5 | 93.4 | 82.9 |
| Example 13 | 99.5 | 98.5 | 91.5 | 79.2 |
| Example 14 | 99.4 | 98.3 | 91.4 | 78.8 |
| Comparative Example 3 | 99.1 | 96.3 | 87.7 | 67.9 |
| Comparative Example 4 | 99.3 | 97.8 | 89.9 | 77.1 |

As shown in Table 3 and Table 4, the positive electrode for a lithium secondary battery according to the present invention can easily estimate and/or measure the state of charge (SOC), and it can be seen that not only the heat generation phenomenon during charging and discharging is improved, but also the output performance is excellent.

Specifically, it was confirmed that the positive electrode of the Examples according to the present invention had change in voltage per SOC 1% in the second section including the state of charge (SOC) of 50% increase to 43.1mV or more. In particular, in the case of a battery containing lithium iron phosphate (LiFePO₄) as the positive electrode active material, it was confirmed that the change in voltage per SOC 1% in the first and third sections, where the voltage difference according to the change in state of charge (SOC) is insignificant, exhibited a large voltage deviation of 11.8 mV or more and 2.9 mV or more respectively. This means that the state of charge (SOC) of the battery can be easily estimated with high reliability.

In addition, it can be seen that the positive electrode of the Examples has low internal and external temperatures of less than 55°C and less than 43°C, respectively, during overcharging. This means that the safety of the secondary battery including the positive electrode is high.

Furthermore, it was shown that the lithium secondary batteries including the positive electrode of the Examples maintained a discharge capacity ratio of 90% or more even when discharged at a high rate of 5.0C-rate or more. This means that the output of the lithium secondary battery including the positive electrode of the Examples is excellent.

From these results, since the positive electrode according to the present invention can display a large voltage deviation for each state of charge (SOC) of a secondary battery, it is possible to easily estimate and/or measure the state of charge (SOC) with high reliability when applied to a secondary battery, and it can be known that not only the safety of the secondary battery is excellent due to an improvement in heat generation phenomenon during charging and discharging, but also has an excellent effect of improving the output performance of the secondary battery.

As described above, the present invention has been described with reference to preferable exemplary embodiments, but it should be understood by those skilled in the art or those of ordinary skill in the art that the present invention can be variously modified and changed without departing from the spirit and technical scope of the present invention described in the accompanying claims.

Therefore, the technical scope of the present invention should not be limited to the contents described in the detailed description of the specification, but should be defined by the claims.

### [Reference Numerals]

1: POSITIVE ELECTRODE FOR LITHIUM SECONDARY BATTERY
10: POSITIVE ELECTRODE CURRENT COLLECTOR
20: MULTI-LAYERED POSITIVE ELECTRODE MIXTURE LAYER
21: INDIVIDUAL POSITIVE ELECTRODE MIXTURE LAYER
21a: FIRST POSITIVE ELECTRODE MIXTURE LAYER
21b: N^{TH} POSITIVE ELECTRODE MIXTURE LAYER

## Claims

1. A positive electrode for a lithium secondary battery, the positive electrode comprising:
a positive electrode current collector; and
n positive electrode mixture layers are positioned on a positive electrode current collector, where n≥2,
wherein a first positive electrode mixture layer contacting a surface of the positive electrode current collector contains a first positive electrode active material comprising an iron phosphate compound represented by Formula 1 below, and
wherein the second to n^{th} positive electrode mixture layers disposed on the first positive electrode mixture layer comprise the first positive electrode active material comprising the iron phosphate compound represented by Formula 1, and a second positive electrode active material comprising a lithium composite metal oxide represented by Formula 2.
[Formula 1] LiFeₐM¹₁₋ₐXO₄
[Formula 2] Liₓ[Ni_{y}Co_{z}Mn_{w}M²ᵥ]O₂
In Formula 1 and Formula 2,
M¹ is one or more elements selected from the group consisting of W, Cu, Fe, V, Cr, Co, Ni, Mn, Ti, Zr, Zn, Al, In, Ta, Y, La, Sr, Ga, Sc, Gd, Sm, Ca, Ce, Nb, Mg, B, and Mo,
X is one or more elements selected from the group consisting of P, Si, S, As, and Sb,
a is 0≤a≤0.5,
M² is one or more elements selected from the group consisting of W, Cu, Fe, V, Cr, Ti, Zr, Zn, Al, In, Ta, Y, La, Sr, Ga, Sc, Gd, Sm, Ca, Ce, Nb, Mg, B, and Mo, and
x, y, z, w, and v are 1.0≤x≤1.30, 0.1≤y<1, 0≤z≤1, 0≤w≤1, 0≤v≤0.1, respectively, where y+z+w+v=1.

2. The positive electrode for a lithium secondary battery of claim 1, wherein a concentration of the second positive electrode active material increases from the second positive electrode mixture layer in contact with the first positive electrode mixture layer to the n^{th} positive electrode mixture layer most spaced apart from the first positive electrode mixture layer.

3. The positive electrode for a lithium secondary battery of claim 1, wherein the second positive electrode active material is included in an amount of less than 10 wt.% based on a total weight of the n positive electrode mixture layers.

4. The positive electrode for a lithium secondary battery of claim 1, wherein the second positive electrode active material is included in each of the second to n^{th} positive electrode mixture layers in an amount of 0.5 to 20 wt.% based on the weight of each of the second to n^{th} positive electrode mixture layers.

5. The positive electrode for a lithium secondary battery of claim 1, wherein a total thickness of the n positive electrode mixture layers is 50µm to 200µm.

6. The positive electrode for a lithium secondary battery of claim 1, wherein a thickness of the first positive electrode mixture layer is 10% to 60% of the total thickness of the n positive electrode mixture layers.

7. The positive electrode for a lithium secondary battery of claim 1, wherein an average particle size of the first positive electrode active material contained in each of the first to n^{th} positive electrode mixture layer decreases from the first positive electrode mixture layer to the n^{th} positive electrode mixture layer.

8. The positive electrode for a lithium secondary battery of claim 1, wherein an average particle size of the second positive electrode active material contained in each of the second to n^{th} positive electrode mixture layer increases from the second positive electrode mixture layer in contact with the first positive electrode mixture layer to the n^{th} positive electrode mixture layer most spaced apart from the first positive electrode mixture layer.

9. The positive electrode for a lithium secondary battery of claim 1, wherein when applied to a secondary battery, the positive electrode has a change in voltage of 5mV to 60mV per SOC 1% in a range of SOC 30 to 70%.

10. The positive electrode for a lithium secondary battery of claim 1, wherein the positive electrode has a change in voltage of 0.1mV to 60mV per SOC 1% in a range of SOC 65 to 95%.

11. An electrode assembly for a lithium secondary battery, the electrode assembly comprising:
the positive electrode according to claim 1;
a negative electrode; and
a separator interposed between the positive electrode and the negative electrode.

12. The electrode assembly for a lithium secondary battery of claim 11, wherein a negative electrode comprises a negative electrode current collector, and a negative electrode mixture layer disposed on the negative electrode current collector, and
wherein the negative electrode mixture layer comprises one or more carbon-based negative electrode active materials of natural graphite, artificial graphite, expanded graphite, hard carbon, soft carbon, carbon fiber, carbon black, carbon nanotube, fullerene, activated carbon, acetylene black, or ketjen black.

13. A lithium secondary battery, comprising:
the electrode assembly according to claim 11;
a battery case into which the electrode assembly is inserted; and
an electrolyte composition injected into a battery case together with an electrode assembly.

14. The lithium secondary battery of claim 13, wherein the lithium secondary battery is **characterized in that** it is a prismatic secondary battery.
